(19) Europäisches Patentamt / European Patent Office / Office européen des brevets

(11) **EP 2 866 118 A1**

(12) **EUROPEAN PATENT APPLICATION**

(43) Date of publication:
**29.04.2015 Bulletin 2015/18**

(21) Application number: **14181892.2**

(22) Date of filing: **22.08.2014**

(51) Int Cl.:
*G05D 23/24* (2006.01)   *H01C 7/00* (2006.01)
*H01L 21/48* (2006.01)   *H01C 7/04* (2006.01)
*H01L 49/02* (2006.01)   *H01L 21/02* (2006.01)
*H01C 17/065* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.10.2013 US 201361961767 P**

(71) Applicant: **Nano and Advanced Materials Institute Limited**
**Hong Kong (CN)**

(72) Inventor: **Sun, Caiming**
**HONG KONG (HK)**

(74) Representative: **Cabinet Chaillot**
**16/20, avenue de l'Agent Sarre**
**B.P. 74**
**92703 Colombes Cedex (FR)**

(54) **Thin film with negative temperature coefficient behavior and method of making thereof**

(57)   A conductive thin film including a binder matrix and semiconductor nanowires dispersed therein is disclosed. The semiconductor nanowires are in the range of 30% to 50% by weight percentage of the thin film. The present invention also discloses a method of making such thin film. The method includes the steps of: mixing a plurality of semiconductor nanowires with a polymer binder to obtain a printing ink; thinning the printing ink with a solvent to achieve a predetermined viscosity; printing the printing ink on a substrate to form a conductive thin film thereon and evaporating the solvent at a rate slower than the evaporation rate of water.

| Immersing a silicon wafer into an etching solution | 22 |
| Releasing the silicon nanowires from the etched silicon wafer | 24 |
| Separating the silicon nanowires from the ultrasonic bath | 26 |
| Mixing the silicon nanowires with polymer binder | 28 |
| Thinning the mixture to obtain a printing ink | 30 |
| Forming a thin film using the printing ink | 32 |

20

FIG. 1

**Description**

CROSS-REFERENCE TO RELATED APPLICATION

This application claims the priority of U.S. Provisional Application No. 61/961,767 filed October 23, 2013, the whole of which is hereby incorporated by reference herein.

FIELD OF INVENTION

The present invention relates to a thin film, in particular a thin film with negative temperature coefficient behavior.

BACKGROUND OF INVENTION

Thin films with negative temperature coefficient behaviour have shown a wide range of opportunities in industrial and consumer applications, such as compensation of thermal effects in electronic circuits and thermal management in high-power electronic systems. Traditionally, these thin films are made of transition-metal oxide, for instance $MnO_2$, CoO and NiO with the process of ceramic technology. Such technology required sintering of powders at high temperature (up to 900 °C) which in turn limits the substrate materials that can be used, precluding the use of many lightweight, flexible materials such as paper and polymer film.

Recently, some researchers proposed a printable material based on silicon particles in size range of 10 $nm$ to 100 $\mu m$. In order to guarantee the reproducibility, a silicon fraction of over 80 % is used in the thin films. Moreover, the electrical transport through this silicon layer is chiefly governed by nanoparticle interconnections. Therefore surface oxidation of these nanoparticles must be prevented, which is a challenge to the synthesis process.

SUMMARY OF INVENTION

In the light of the foregoing background, it is an object of the present invention to provide an alternate composition of a thin film with negative temperature coefficient behaviour and the method of making thereof.

In one aspect, the present invention is a conductive thin film including a binder matrix and semiconductor nanowires dispersed therein, wherein the semiconductor nanowires are in the range of 30 % to 50 % by weight percentage of the thin film.

In one embodiment, the temperature coefficient of resistance of the thin film is in the range of 5 %/°C to 8.1 %/°C.

In yet another embodiment, the semiconductor nanowires are dispersed within domains, wherein the domains having diameters of 100 $\mu m$ to 1000 $\mu m$.

According to another aspect of the present invention, a method of producing a conductive thin film is disclosed. The method includes the steps of: mixing a plurality of semiconductor nanowires with a polymer binder to obtain a printing ink; and printing the printing ink on a substrate to form the conductive thin film thereon. The semiconductor nanowires are in the range of 30 % to 50 % by weight percentage of the thin film.

In one embodiment, the method further includes the steps of thinning the printing ink with a solvent to achieve a predetermined viscosity and evaporating the solvent at an evaporation rate slower than the evaporation rate of water.

In one embodiment, the solvent is selected from a group consisting of polyethylene glycol and ethylene glycol.

In another aspect, the present invention is a conducting ink formed by a process including the steps of mixing a plurality of semiconductor nanowires with a polymer binder to obtain a mixture and thinning the mixture with a solvent to achieve a predetermined viscosity of the ink. The semiconductor nanowires are in the range of 30 % to 50 % by weight percentage of the ink and the solvent has an evaporation rate slower than $10^{-4}$ kg/m$^2$-s at around room temperature and ambient environment).

The present invention can be conducted at room temperature without involving high temperature, high pressure, or costly equipment and hazardous materials. Furthermore, nanowires bear higher crystal quality than nanoparticles. Sparsely interconnected nanowire networks form continuous films with good conductivity for electronic devices which can be promisingly applied for semiconductor layer in thin film transistors (TFTs) with great mobility

BRIEF DESCRIPTION OF FIGURES

For a more complete understanding of the present invention, reference is made to the following detailed description and accompanying drawings, in which:

FIG. 1 shows a flow diagram for a process for making a silicon nanowire-based thin film according to one embodiment of the present invention;

FIG. 2 shows the scanning electron microscope (SEM) images of silicon nanowires on an etched silicon wafer according to one embodiment of the present invention. FIG. 2(a) and FIG. 2(b) show the cross-sectional view and the plain view of silicon nanowires respectievly;

FIG. 3 shows the Transmission electron microscopy (TEM) images of a silicon nanowire according to the embodiment as shown in FIG. 2. FIG. 3(a) is a low resolution TEM image showing the whole silicon nanowire and FIG. 3(b) is a high resolution TEM image showing the surface of the silicon nanowire;

FIG. 4 shows a printed silicon nanowire film using 2-Propanol as the solvent according to one embodiment of the present invention. FIG. 4(a) and FIG. 4(b) show an optical photograph and a SEM image of the silicon nanowire film using 2-Propanol as the solvent respectively. FIG. 4(c) is an enlarged image of FIG. 4(b);

FIG. 5 shows a printed silicon nanowire film using water as the solvent according to one embodiment of the present invention. FIG. 5(a) and FIG. 5(b) show an optical photograph and a SEM image of the silicon nanowire film using water as the solvent respectively. FIG. 5(c) is an enlarged image of FIG. 5(b);

FIG. 6 shows a silicon nanowire film formed using drop-casting technique according to one embodiment of the present invention;

FIG. 7 shows a silicon nanowire film formed using screen-printing technique according to one embodiment of the present invention; and

FIG. 8 shows the behaviour of a silicon nanowire film according to one embodiment of the present invention. FIG. 8(a) shows a temperature sensor fabricated using the silicon nanowire film according to one embodiment of the present invention and FIG. 8(b) shows the resistance to temperature curve (R-T curve) of the temperature sensor as shown in FIG. 8(a).

DETAILED DESCRIPTION OF THE PREFERRED EMBODIMENTS

As used herein and in the claims, "comprising" means including the following elements but not excluding others.

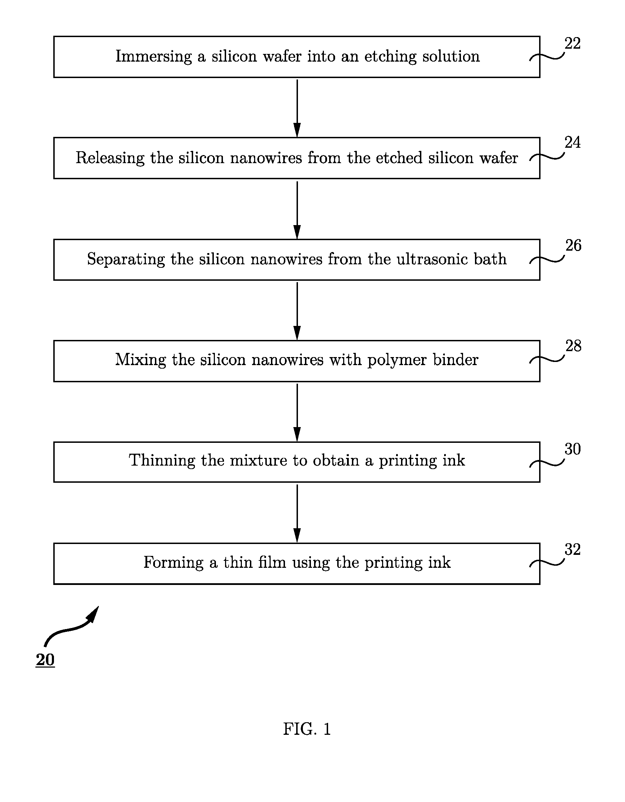

FIG. 1 shows a method 20 of producing silicon nanowire-based thin film. The method 20 begins with a step 22, in which a silicon wafer is immersed into a hydrofluoric acid-silver nitrate (HF-AgNO$_3$) solution, serving as the etching solution, to produce silicon nanowires. In this synthesis, which is known as metal-assisted chemical etching (MaCE), solution-nucleated metal plays the role of a nanoscale electrode in the electrochemical etching of a single-crystalline silicon wafer. The metal nanoparticles, such as silver, oxidize silicon that is in contact with them by taking electrons from silicon. The oxidized silicon, or silicon oxide (SiO$_2$), is then etched away by hydrofluoric acid (HF) in the etching solution, leaving a pit or hole on the silicon surface. As the electrochemical redox reaction proceeds, the metal nanoparticles sink down further and remove underlying silicon. Finally, silicon nanowires result from areas where no metal is present.

The second step 24 of the method 20 is to immerse the etched silicon wafer in a potassium hydroxide (KOH) solution in order to release the silicon nanowires from the etched silicon wafer. Afterwards, the silicon nanowires are dispersed into a solution by an ultrasonic bath and further separated from the dispersions using centrifuge in step 26. The silicon nanowires are then mixed with a polymer binder at step 28 at nanowire-to-binder weight ratios of 1:2 to 1:1. In order to facilitate the afterwards fabrication processing, the viscosity of the mixture of silicon nanowires and the polymer binder are adjusted by adding a solvent therein, thereby obtaining a printing ink, in step 30. The last step 32 of the method 20 is to form a thin film using the printing ink obtained in step 30.

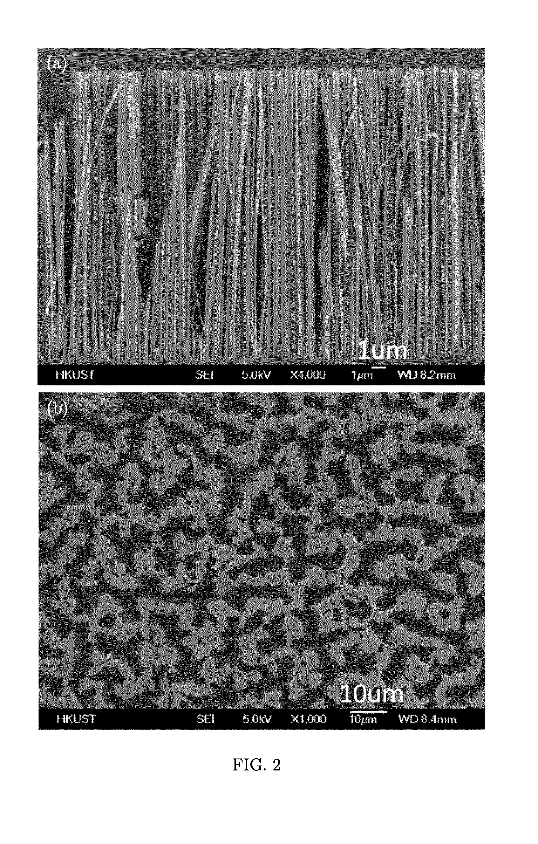

In order to better illustrate the present invention, an example is provided herein. Boron-doped p-type silicon (100) wafer with a resistivity of 15-25Ω-cm was used as a starting wafer for synthesis of silicon nanowires. Etching was performed in an etching solution consisting of 4.8M of HF, 0.03M of AgNO$_3$ and deionized (DI) water for 2 hours at room temperature. The scanning electron microscopy (SEM) images of as-etched silicon nanowires on the wafer are shown in FIG. 2, of which FIG. 2(a) is the cross-sectional and FIG. 2(b) is the plan-view image. It should be observed that a dense, vertical array of silicon nanowires of length about 20 $\mu m$ was obtained.

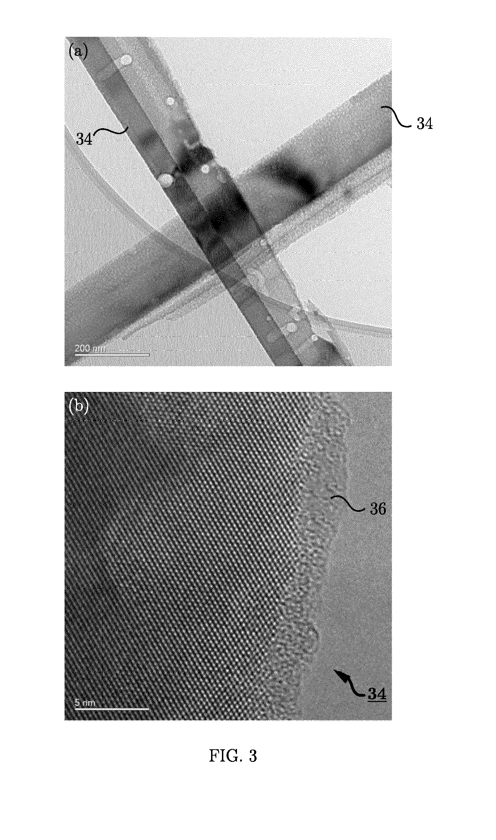

The silicon nanowires were then released into ethanol from as-etched silicon wafers by sonication in an ultrasonic bath. Afterwards, the silicon nanowires in the ethanol were centrifuged three times using rotational speed of 10,000 rpm. The duration of each cycle is 10 minutes. Finally, the silicon nanowires were dried in vacuum oven at 40°C. The morphology of individual silicon nanowire was examined by transmission electron microscopy (TEM). The corresponding images are shown in FIG. 3. Referring to FIG. 3(a), the diameters of silicon nanowires 34 were in the range of 50 nm to 150 nm. Referring now to FIG. 3(b), which is a high-resolution TEM image of the surface of a particular silicon nanowire 34, a native silicon oxide 36 layer below 2 nm was found on the surface of the silicon nanowire 34. This indicates that the surface oxidation of silicon nanowires 34 can be ignored for electrical interconnection between silicon nanowires 34 in the MaCE process. From weight measurements on the wafer before and after the release of the silicon nanowires, it was found that about 50 % of silicon in the wafer was fabricated to silicon nanowires. Therefore, for standard 4-inch silicon starting wafers as used in the present example, more than one gram of silicon nanowires can be obtained by the aforesaid process.

After obtaining the silicon nanowires, a printing ink is obtained by mixing the silicon nanowires with a polymer binder and a solvent. In order to achieve a desirable resistance of the resulting thin film, which is in an order of MΩ, a solvent with evaporation rate slower than that of water is used. In order to illustrate the effect of the evaporation rate of the solvent to the resulting thin film, three inks with different composition were prepared.

**EXAMPLE 1**

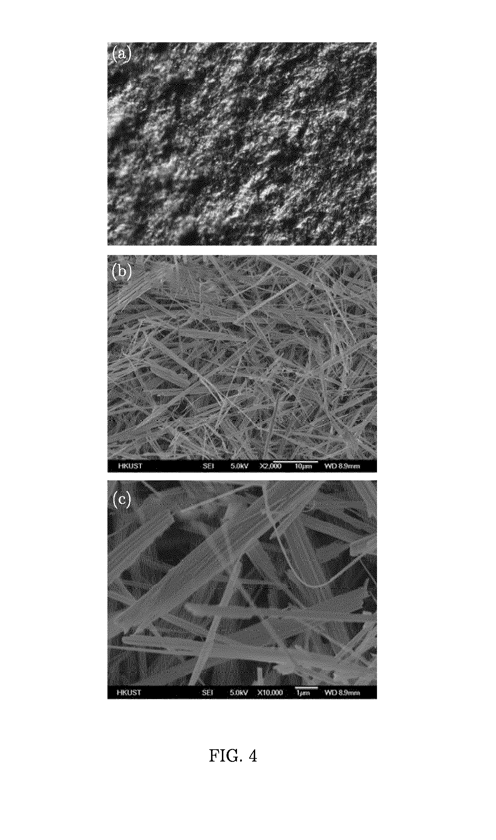

In this example, 2-propanol was used as the solvent, 0.1g of silicon nanowires obtained using the aforesaid method were mixed with 0.1g of commercial polymer binder (LUMITEX - GBX, Karan Texchem Pvt. Ltd.), which was dissolved in 2ml of 2-Propanol. Afterwards, a thin film, which is shown in FIG. 4(a), was obtained by screen printing this ink over a substrate. Referring to FIG. 4(b) and FIG. 4(c), scanning electron microscope (SEM) images of the thin film as shown in FIG. 4(a) and an enlarged image of the central portion of the thin film are shown respectively. It should be observed that the silicon nanowires are randomly distributed in the thin film which results into a very high resistivity, i.e. over GΩcm. It is because propanol is very easy to vaporize and make the printed film dry quite fast. There is no enough time for silicon nanowire to assemble during this fast solvent evaporation. Such a high resistivity makes the printed film not suitable for any NTC applications.

**EXAMPLE 2**

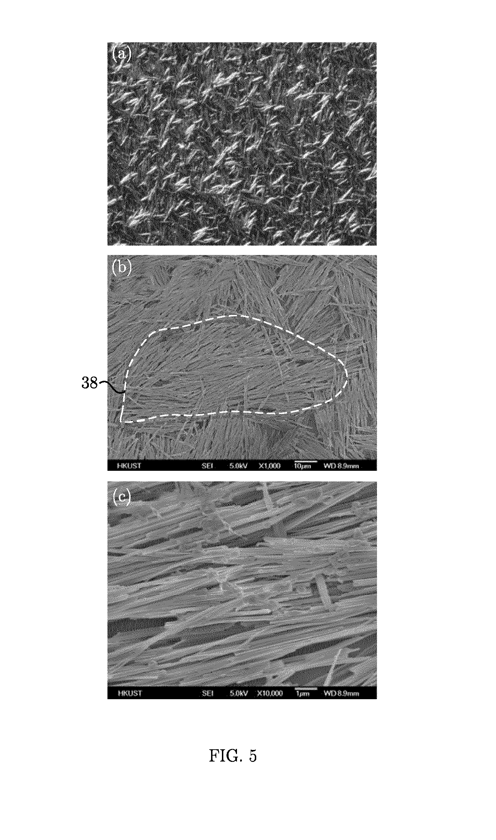

Deionized water was used as the solvent of the printing ink in the second example. 0.1g of silicon nanowires and 0.1g of commercial polymer binder (LUMITEX - GBX, Karan Texchem Pvt. Ltd.) dissolved in 2ml of deionized water was used. The thin film obtained thereof is shown in FIG. 5(a). FIG. 5(b) is the SEM image of the thin film as shown in FIG. 5(a). Well-aligned nanowires within domain 38 are observed therein. The domain 38, as shown in FIG. 5(b) and (c), has a diameter of 100 $\mu m$. It should be noted that silicon nanowires are also found within the thin film in areas where a domain cannot be defined. The resistivity ~10MΩ-cm of this thin film is much lower than that obtained in the first example. It is because that the well-aligned silicon nanowires contribute to electrical path which makes this printed film a desirable NTC material.

**EXAMPLE 3**

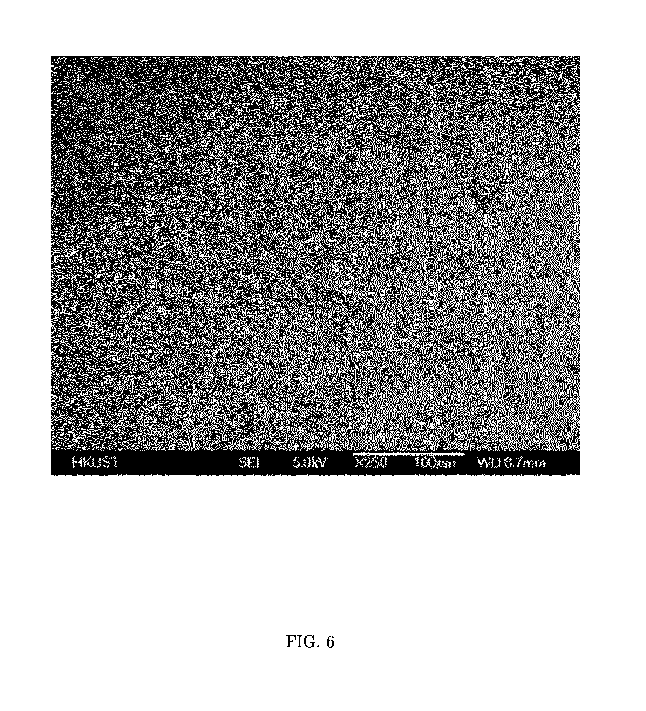

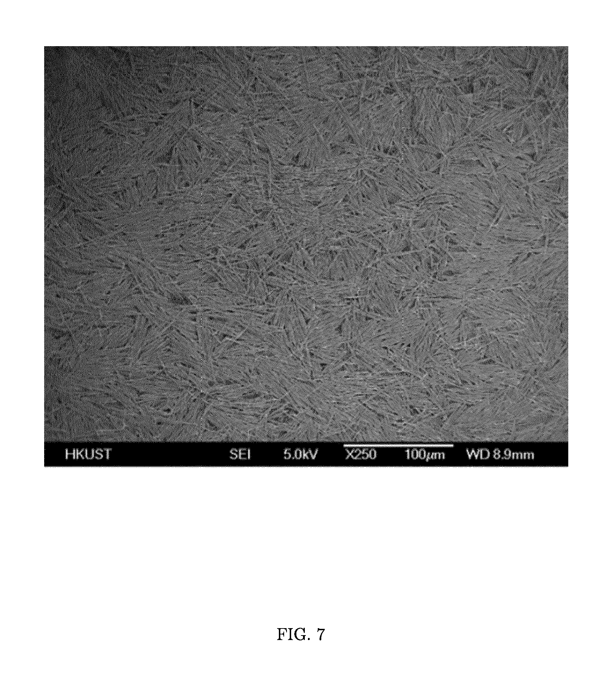

In the third example, 100mg of commercial polymer binder (LUMITEX - GBX, Karan Texchem Pvt. Ltd.) was dissolved into 0.7ml of ethylene glycol, serving as a solvent. After addition of 0.1g silicon nanowires, the mixtures were homogenized in a rotary mixer for two minutes. Eventually, two silicon nanowire-based thin films were formed by drop casting the printing ink onto predefined patterns, 1cm X 1cm square, and screen printing respectively. The thin films were examined using scanning electron microscope after drying overnight. The SEM image of the thin film obtained using drop casting and screen printing are shown in FIG. 6 and FIG. 7 respectively. Both drop-casted and screen-printed films show continuous films. The drop-casted film has a thickness over 100 $\mu m$ with high surface roughness as shown in FIG. 6, whereas for the screen-printed layer, the thickness is 10 $\mu m$ and the surface is smoother compared to the drop-casted film.

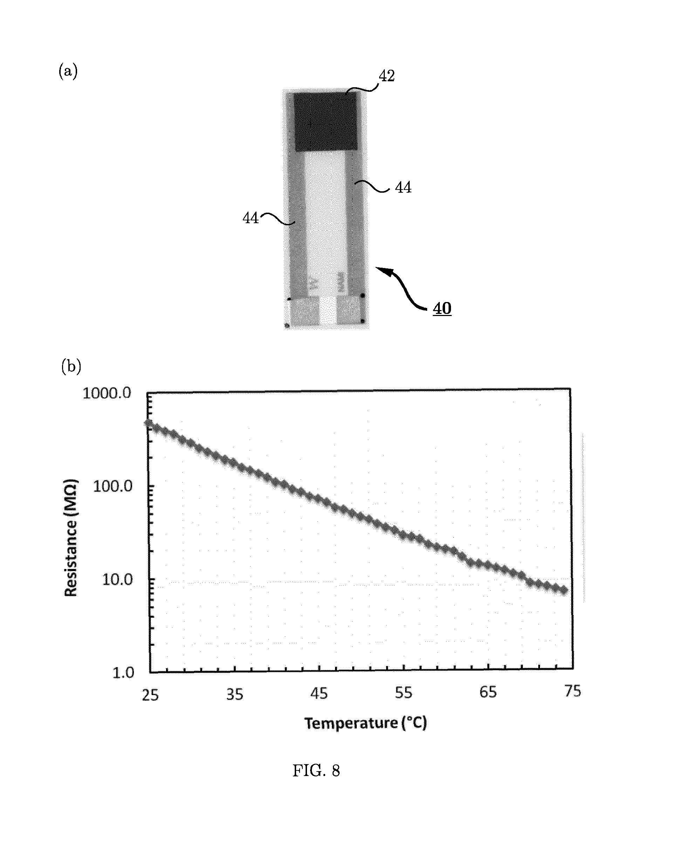

One 1cm X 1cm temperature sensor was then fabricated using the screen-printed thin film as shown in FIG. 7. FIG. 8(a) shows the temperature sensor 40 obtained therefrom. The temperature sensor 40 includes a 1cm×1cm thin film 42and two electrodes 44. The electrodes 44 are coupled to the thin film 42 at two opposing ends. The resistance change of the temperature sensor 40 with respect to temperature change was then measured. The corresponding resistance to temperature curve (R-T curve) of the temperature sensor 40 is shown in FIG. 8(b). The temperature sensor 40 shows a negative temperature coefficient behaviour as governed by equation (1).

$$R = R_{25}\ exp(\frac{B}{T} - A) \qquad\qquad (1)$$

where $R$ is the resistivity as a function of temperature $T$, $B$ is the material constant and correlates with temperature

sensitivity, and $R_{25}$ is the resistance at 25 °C as reference.

From the R-T curve as shown in FIG. 8(b), the temperature coefficient of resistance $\alpha$, which is governed by equation (2), of the thin film 42 of the temperature sensor 40 is 8.1 %/°C in average from 25°C to 75°C, which approaches the reported value of 8.0-9.5%/°C for intrinsic silicon bulk material near room temperature.

$$\alpha = \frac{1}{R}\frac{dR}{dT} \qquad (2)$$

where $\alpha$ is the temperature coefficient of resistance and R is the resistivity as shown in equation (1).

The exemplary embodiments of the present invention are thus fully described. Although the description referred to particular embodiments, it will be clear to one skilled in the art that the present invention may be practiced with variation of these specific details. Hence this invention should not be construed as limited to the embodiments set forth herein.

For example, silicon nanowires are used in the aforementioned embodiments and example. However, other semiconductor nanowire, for instance germanium and metal oxide semiconductor nanowires, may be used according to the user's preference. Furthermore, deionized water and ethylene glycol are used as the solvent in the printing ink. Other solvent with evaporation rate slower than that of water, for instance polyethylene glycol, could also be used.

Sonication with the help of potassium hydroxide is adopted to release the silicon nanowires from an etched silicon wafer in the aforesaid examples. Nonetheless, mechanical scraping by razor blade and wet chemical etching by alkali hydroxides can also be adopted to release the nanowires from the etched wafer.

**Claims**

1. A conductive thin film comprising a binder matrix and semiconductor nanowires dispersed therein, wherein said semiconductor nanowires are in the range of 30 % to 50 % by weight percentage of said thin film.

2. The conductive thin film of claim 1, wherein the temperature coefficient of resistance of said thin film is 5%/°C-8.1 %/°C.

3. The conductive thin film of claim 1, wherein said semiconductor nanowires are dispersed within domains, said domains having diameters of $100\mu m$ to $1000\mu m$.

4. The conductive thin film of claim 1, wherein said semiconductor nanowires are laterally dispersed in said thin film.

5. The conductive thin film of claim 1, wherein said semiconductor nanowires are made of a material selected from a group consisting of silicon, germanium and metal oxide.

6. A method of producing a conductive thin film comprising the steps of:

   a. mixing a plurality of semiconductor nanowires with a polymer binder to obtain a printing ink; and
   b. printing said printing ink on a substrate to form said conductive thin film thereon;

   wherein said semiconductor nanowires are in the range of 30 % to 50 % by weight percentage of said thin film.

7. The method of claim 6 further comprising the steps of:

   a. thinning said printing ink with a thinner to achieve a predetermined viscosity; and
   b. evaporating said thinner at a rate slower than the evaporation rate of water.

8. The method of claim 7, wherein said evaporation rate of water is $10^{-4}kg/m^2$-s at room temperature and ambient environment.

9. The method of claim 7, wherein said thinner is selected from a group consisting of polyethylene glycol and ethylene glycol.

10. The method of claim 7, wherein said predetermined viscosity in the range of 100cps to 10,000cps.

11. The method of claim 6, wherein said step of printing said printing ink is conducted using a technique selected from a group consisting of screen printing technique and drop casting technique.

12. The method of claim 6 further comprising a step of producing said semiconductor nanowires by metal-assisted chemical etching, wherein said step of producing said semiconductor nanowires further comprises the steps of:

   a. providing a semiconductor wafer;
   b. etching said semiconductor wafer in an etching solution to form an etched wafer; and
   c. immersing said etched wafer in a potassium hydroxide solution to release said semiconductor nanowires from said etched wafers;

   wherein said metal-assisted chemical etching is conducted under room temperature for two hours.

13. The method of claim 12, wherein said etching solution comprises:

   a. 4.8M of hydrofluoric acid;
   b. 0.03M of silver nitrate; and
   c. deionized water.

14. The method of claim 12 further comprising the steps of:

   a. dispersing said silicon nanowires into a solution by an ultrasonic bath;
   b. centrifuging said solution to separate said semiconductor nanowires dispersed therein; and
   c. drying said semiconductor nanowires on vacuum oven;

   wherein said step of centrifuging is performed three times at 10,000 rpm and each cycle is 10 minutes; wherein said step of drying is conducted at 40°C.

15. A conducting ink formed by a process comprising the steps of:

   a. mixing a plurality of semiconductor nanowires with a polymer binder to obtain a mixture; and
   b. thinning said mixture with a thinner to achieve a predetermined viscosity of said ink;

   wherein said semiconductor nanowires are in the range of 30 % to 50 % by weight percentage of said ink and said thinner has an evaporation rate slower than the evaporation rate of water

16. The conducting ink of claim 15, wherein said evaporation rate of water is $10^{-4}kg/m^2$-s at room temperature and ambient environment.

17. The conducting ink of claim 15, wherein said thinner is selected from a group consisting of polyethylene glycol and ethylene glycol.

18. The conducting ink of claim 15, wherein said predetermined viscosity in the range of 100cps to 10,000cps.

19. The conducting ink of claim 15, wherein said semiconductor nanowires are made of a material selected from a group consisting of silicon nanowires, germanium nanowires and metal oxide semiconductors.

```
┌─────────────────────────────────────────────────────────────┐
│   Immersing a silicon wafer into an etching solution         │  22
└─────────────────────────────────────────────────────────────┘
                              │
                              ▼
┌─────────────────────────────────────────────────────────────┐
│  Releasing the silicon nanowires from the etched silicon wafer │  24
└─────────────────────────────────────────────────────────────┘
                              │
                              ▼
┌─────────────────────────────────────────────────────────────┐
│  Separating the silicon nanowires from the ultrasonic bath   │  26
└─────────────────────────────────────────────────────────────┘
                              │
                              ▼
┌─────────────────────────────────────────────────────────────┐
│   Mixing the silicon nanowires with polymer binder           │  28
└─────────────────────────────────────────────────────────────┘
                              │
                              ▼
┌─────────────────────────────────────────────────────────────┐
│   Thinning the mixture to obtain a printing ink              │  30
└─────────────────────────────────────────────────────────────┘
                              │
                              ▼
┌─────────────────────────────────────────────────────────────┐
│   Forming a thin film using the printing ink                 │  32
└─────────────────────────────────────────────────────────────┘
```

20

FIG. 1

FIG. 2

FIG. 3

FIG. 4

FIG. 5

HKUST    SEI    5.0kV    X250    100µm    WD 8.7mm

FIG. 6

FIG. 7

(a)

(b)

FIG. 8

Europäisches
Patentamt

European
Patent Office

Office européen
des brevets

## EUROPEAN SEARCH REPORT

Application Number

EP 14 18 1892

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2012/035494 A1 (UNIV CAPE TOWN [ZA]; BRITTON DAVID THOMAS [ZA]; HARTING MARGIT [ZA]) 22 March 2012 (2012-03-22) | 1-13, 15-19 | INV.<br>G05D23/24<br>H01C7/00 |
| A | * pages 1-3,5,8; claim 17 * | 14 | H01L21/48<br>H01C7/04 |
| Y | WO 2004/050350 A1 (NANOPRODUCTS CORP [US]; YADAV TAPESH [US]) 17 June 2004 (2004-06-17) | 1-13, 15-19 | H01L49/02<br>H01L21/02<br>H01C17/065 |
| A | * paragraphs [0007], [0016], [0031], [0054] - [0056], [0061]; claims 1,3 * | 14 | |
| A | EP 2 226 618 A2 (XEROX CORP [US]) 8 September 2010 (2010-09-08) * paragraph [0016] * | 1-19 | |
| Y | WO 2007/083152 A1 (IMP INNOVATIONS LTD [GB]; GREEN MINO [GB]) 26 July 2007 (2007-07-26) * pages 5,7,9 * | 12,13 | |
| Y | HUANG Z ET AL: "Metal-Assisted Chemical Etching of Silicon: A Review", ADVANCED MATERIALS, WILEY - V C H VERLAG GMBH & CO. KGAA, DE, vol. 23, no. 2, 11 January 2011 (2011-01-11), pages 285-308, XP002667196, ISSN: 0935-9648, DOI: 10.1002/ADMA.201001784 [retrieved on 2010-09-21] * page 285 * | 12,13 | TECHNICAL FIELDS SEARCHED (IPC)<br><br>G05D<br>H01C<br>H01L |
| A | WO 2007/072162 A1 (UNIV CAPE TOWN [ZA]; BRITTON DAVID THOMAS [ZA]; ODO EKUNDARE AYODELE []) 28 June 2007 (2007-06-28) * pages 3,6,8 * | 1-19 | |

The present search report has been drawn up for all claims

| Place of search | Date of completion of the search | Examiner |
|---|---|---|
| Munich | 18 March 2015 | Lescop, Emmanuelle |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.** EP 14 18 1892

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2015

| Patent document cited in search report | | Publication date | Patent family member(s) | | Publication date |
|---|---|---|---|---|---|
| WO 2012035494 | A1 | 22-03-2012 | CN | 103210290 A | 17-07-2013 |
| | | | EP | 2616784 A1 | 24-07-2013 |
| | | | JP | 2013538462 A | 10-10-2013 |
| | | | KR | 20130128383 A | 26-11-2013 |
| | | | US | 2013203201 A1 | 08-08-2013 |
| | | | WO | 2012035494 A1 | 22-03-2012 |
| WO 2004050350 | A1 | 17-06-2004 | AU | 2003295914 A1 | 23-06-2004 |
| | | | US | 2006137567 A1 | 29-06-2006 |
| | | | US | 2011166289 A1 | 07-07-2011 |
| | | | WO | 2004050350 A1 | 17-06-2004 |
| EP 2226618 | A2 | 08-09-2010 | BR | PI1000534 A2 | 26-07-2011 |
| | | | CA | 2694458 A1 | 02-09-2010 |
| | | | CN | 101858794 A | 13-10-2010 |
| | | | EP | 2226618 A2 | 08-09-2010 |
| | | | JP | 2010206202 A | 16-09-2010 |
| | | | KR | 20100099061 A | 10-09-2010 |
| | | | US | 2010221517 A1 | 02-09-2010 |
| WO 2007083152 | A1 | 26-07-2007 | BR | PI0707164 A2 | 02-08-2011 |
| | | | CA | 2637737 A1 | 26-07-2007 |
| | | | CN | 101390198 A | 18-03-2009 |
| | | | EP | 1977443 A1 | 08-10-2008 |
| | | | JP | 5043041 B2 | 10-10-2012 |
| | | | JP | 2009524264 A | 25-06-2009 |
| | | | KR | 20090004858 A | 12-01-2009 |
| | | | US | 2010233539 A1 | 16-09-2010 |
| | | | WO | 2007083152 A1 | 26-07-2007 |
| WO 2007072162 | A1 | 28-06-2007 | CN | 101346441 A | 14-01-2009 |
| | | | EP | 1971651 A1 | 24-09-2008 |
| | | | JP | 5106414 B2 | 26-12-2012 |
| | | | JP | 2009520866 A | 28-05-2009 |
| | | | KR | 20080100170 A | 14-11-2008 |
| | | | US | 2009004832 A1 | 01-01-2009 |
| | | | WO | 2007072162 A1 | 28-06-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61961767 A